# EUROPEAN PATENT APPLICATION

(11) **EP 2 073 026 A2**
(43) Date of publication of application: **24.06.2009**
(21) Application number: 08171716.7
(22) Date of filing: 15.12.2008
(51) Int. Cl.: G01R 15/24

(54) **Fiber optic current sensor and method for sensing current using the same**

(30) Priority: 21.12.2007 US 963371
(71) Applicant: Honeywell International Inc., Morristown, NJ 07962 (US)
(72) Inventor: Sanders, Glen A., Morristown, NJ 07962 (US); Sanders, Steve J., Morristown, NJ 07962 (US)
(74) Representative: Buckley, Guy Julian

(57) **Abstract**

An apparatus and method for sensing current. The apparatus includes an optical fiber (14) having first and second opposing ends, a recirculator (22) configured such that when light propagates from the respective first and second ends of the optical fiber, at least some of the light is reflected, directed or passed by the recirculator into the respective opposing ends of the optical fiber to propagate through the optical fiber and form an optical loop having an opening there through.

## Description

### BACKGROUND OF THE INVENTION

Ring laser gyroscopes (RLGs) and interferometric fiber optic gyroscopes (IFOGs) have become widely used technologies in many systems, typically to sense the rotation and angular orientation of various objects, such as aerospace vehicles. Both RLGs and IFOGs work by directing light in opposite directions around a closed optical path that encloses an area having a normal along an axis of rotation. If the device is rotated about this axis of rotation, the optical path length for the light traveling in one direction is reduced, while the optical path length for the light traveling in the opposite direction is increased. The change in path length causes a phase shift between the two light waves that is proportional to the rate of rotation.

Generally speaking, the signal to noise or sensitivity of such gyroscopes increases as the optical path lengths and diameters of the closed optical path are increased. To exploit this sensitivity increase, both RLGs and IFOGs direct light around the axis of rotation multiple times. In RLGs, a series of mirrors is used to repeatedly reflect the light around the axis, forming a high finesse resonator. In IFOGs, the light travels around the axis through a coil with numerous turns of optical fiber, often resulting in a path length of several kilometers. Both the recirculation of the RLG and the numerous fiber turns in the IFOG are means of increasing performance of the sensor - a longer optical path produces more signal to noise sensitivity to rotation. In an IFOG, for instance, more turns of coil fiber yield a higher-performance sensor. The RLG uses recirculation to maximize performance, but the RLG path length cannot easily be scaled by the analogy of more fiber turns.

In recent years, resonator fiber optic gyroscopes (RFOGs) have been developed which combine the above-described path length benefits of RLGs and IFOGs into a single device that recirculates light inside a multi-turn fiber optic coil. That is, by recirculating the light within the coil, the coil becomes part of an optical resonator. The resonator typically uses an optical element ("recirculating device") that provides for coupling light from the a light source into the coil and, that allows, or provides for, recirculating light a plurality of times in the fiber coil. The recirculating element is an optical element or elements, and may be for instance, a mirror or a fiber coupler. The combination of the recirculating device and a multi-turn optical fiber coil form a very long path-length optical resonator. These combined performance benefits of RLGs and IFOGs allow RFOGs to provide performance superior to that of either an RLG or an IFOG of equal size. Alternatively, the RFOG can use shorter optical fiber coils and hence be considerably smaller than either RLGs or IFOGs for a given performance level.

One potential difficulty associated with RFOGs is that phase shifts can occur that are not attributable to rotation, but rather to the fact that monochromatic light is propagating in the (finitely nonlinear) glass medium provided by a conventional optical fiber. These phase shifts manifest as rate bias offsets in a gyroscope. These bias offset problems associated with RFOGs for rotation measurement can apply to current sensing as well, in that phase shifts can occur that are not attributable to the presence of electric current. These errors may be attributed to the propagation of monochromatic light in a glass medium, as specifically optical Kerr Effect, as provided by a conventional optical fiber.

Even more recently, Sagnac interferometers, like those used in IFOGs, have been used to sense other phenomena, such as electric current. Typically, the implementation of such sensors, as well as RFOGs, is difficult and expensive. One cause of this expense is that previous designs typically incorporate many costly discrete optical components, each having expensive packaging, and often having optical coupling into optical fibers. Assembly of these sensors typically requires manual splicing and handling of numerous fiber-pigtailed components, which is laborious and costly. Compactness of these sensors is also typically limited by the ability to stow fiber and package discrete components manually. A more highly integrated, low cost, small-size, yet high performance device is desirable.

Accordingly, it is desirable to provide a fiber optic current sensor with improved performance and reduced costs. Furthermore, other desirable features and characteristics of the present invention will become apparent from the subsequent detailed description and the appended claims, taken in conjunction with the accompanying drawings and the foregoing technical field and background.

### SUMMARY OF THE INVENTION

An apparatus is provided for sensing current. The apparatus includes an optical fiber having first and second opposing ends and a recirculating device. When light propagates from the respective first and second ends of the optical fiber, at least some of the light is directed or passed by the recirculator into the respective opposing ends of the optical fiber to propagate through the optical fiber and form an optical ring resonator. In addition the recirculating device also provides for introducing light from a laser light source into the resonator, and is capable of providing a tap for tapping a fraction of light out of the resonator. As light passes therethrough, an index of refraction of the optical fiber changes when a current flows through the area enclosed by the optical loop. High performance may be provided by the resonator design, since any optical noise sources such as shot noise translate into lesser uncertainties in the measurement of current. Additional performance enhancements are obtained by using fiber with an enhanced magneto-optic, or Faraday Effect coefficient. Also provided are means for providing Kerr effect compensation that allows for realizing the benefit of a resonator with high Verdet constant fiber yet without the penalty of optical Kerr effect. The use of a resonator also reduces cost, over that of the Sagnac Interferometer (IFOG-type design) since less fiber may be used in a recirculating device. Miniaturization, and further-reduced cost, is provided by locating unpackaged optical components on a tiny silicon chip, i.e. silicon optical bench. The silicon optical bench has the advantage that optical grade surfaces may be formed on the or within the substrate using low cost batch silicon processing techniques. Another advantage is that elements that cannot be formed on or within the substrate can be fabricated elsewhere but placed onto the chip in precisely-defined, registered locations; thus, easing assembly costs. Silicon allows the inclusion of both optics and electronics in a single, mass-producible package.

### BRIEF DESCRIPTION OF THE DRAWINGS

The present invention will hereinafter be described in conjunction with the following drawing figures, wherein like numerals denote like elements:

FIGURE 1 is a top plan schematic view of a current sensor system, according to one embodiment of the present invention, including a substrate and an optical fiber; and

FIGURE 2 is a top plan view of a portion of the current sensor system of FIGURE 1 illustrating the installation of a conductor.

### DETAILED DESCRIPTION OF THE PREFERRED EMBODIMENT

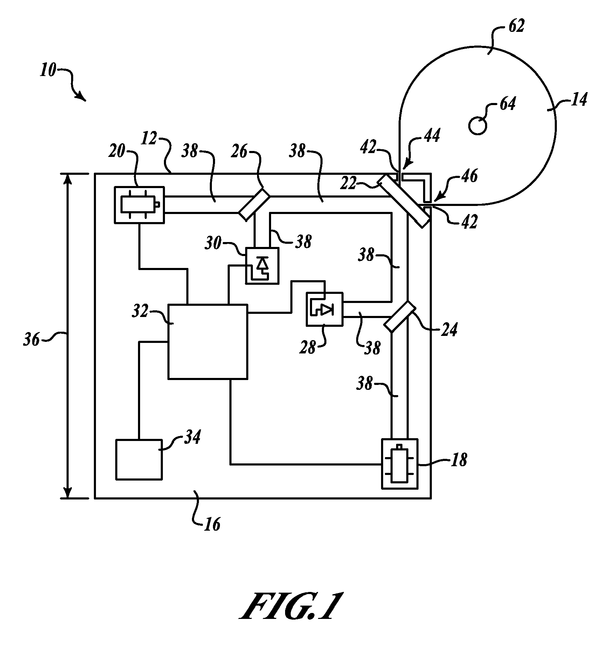

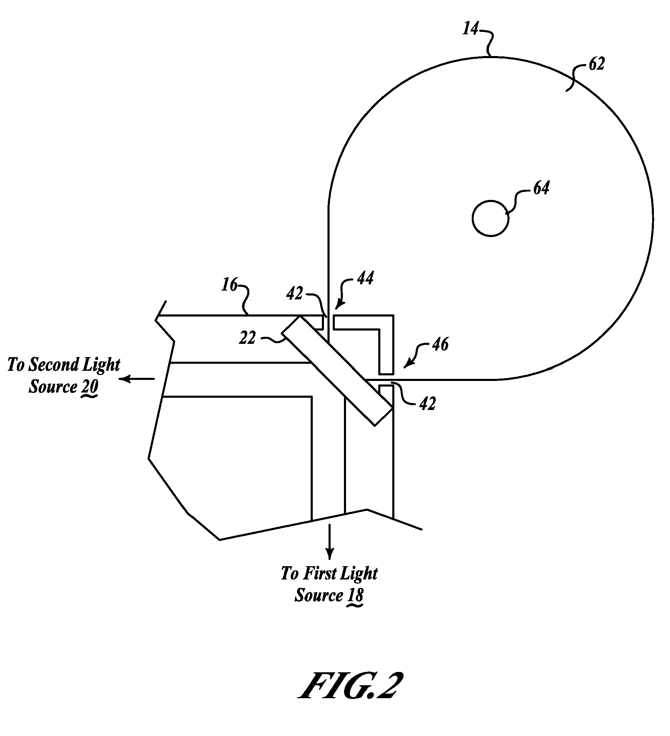

The following detailed description is merely exemplary in nature and is not intended to limit the invention or the application and uses of the invention. Furthermore, there is no intention to be bound by any expressed or implied theory presented in the preceding technical field, background, and brief summary or the following detailed description. It should also be noted that FIGURES 1 and 2 are merely illustrative and may not be drawn to scale.

FIGURES 1 and 2 illustrate a sensing current system 10. The system 10 includes an optical fiber having first and second opposing ends and a recirculator. When light propagates from the respective first and second ends of the optical fiber, at least some of the light is reflected by the recirculator into the respective opposing ends of the optical fiber to propagate through the optical fiber and form an optical loop. An index of refraction of the optical fiber changes from a first value to a second value for light propagation in a first direction around the optical loop and from a third value (e.g., the first value) to a fourth value in a second direction of light propagation around the optical loop when a current flows through the area enclosed by the optical loop.

In one embodiment, a method and apparatus are provided for sensing a current passing through a ring resonator. The ring resonator includes a substrate with a reflector or reflectors mounted or formed thereon and optically coupled to a fiber optic coil. The reflector(s) and fiber define a closed light path or loop. The light path directs each of first and second light beams in a different direction around the closed optical path multiple times. Each of the first and second light beams experience a resonance condition when circulating in the closed optical path. A conductor is placed through the ring resonator. When a current is conducted through the conductor, the first and second light beams propagating in the opposing directions experience changes in the index of refraction, which alters the respective resonance frequencies for the opposing directions. The difference in the resonance frequencies is determined and used to calculate the current flowing through the conductor.

FIGURE 1 illustrates a fiber optic current sensor (or current sensor system) 10 according to one embodiment of the present invention. The fiber optic current sensor 10 includes an integrated optical chip (IOC) 12 and an optical fiber (or fiber optic cable) 14. In the embodiment, the IOC 12 includes a substrate 16 having first and second light sources 18 and 20, a recirculator 22, first and second beam splitters 24 and 26, first and second photo-detectors 28 and 30, a controller 32, and a transmitter 34 formed (or positioned) thereon. As will be described in greater detail below, the current sensor 10 may be understood to be implemented similarly to a gyroscope, in particular, a resonator fiber optic gyro (RFOG), as will be appreciated by one skilled in the art.

The substrate 16 is substantially rectangular (e.g., square) with a side length 36 of, for example, less than 3 centimeters (cm), such as between 5 millimeters (mm) and 1.5 cm, and a thickness of, for example, between approximately 600 and 100 micrometers (µm). In one embodiment, the substrate 16 is made of silicon. It will be appreciated that these dimensions, shape, and materials are merely exemplary, and that the substrate 16 could be implemented according to any one of numerous dimensions, shapes, and materials.

The first and second light sources 18 and 20, at least in the depicted embodiment, are positioned near opposing corners of the substrate 16 and oriented, or "aimed," at a third corner of the substrate 16 and/or the recirculator 22. In one embodiment, the first and second light sources 18 are 20 are laser diodes formed or mounted onto the substrate 16. The laser diodes may be formed by doping a very thin layer on the surface of a doped crystal wafer to form a p-n junction, or diode, having an "n-type" region and a "p-type" region. Although not specifically illustrated, the first and second light sources 18 and 20 may be external cavity laser diodes and each may include a cavity-length modulation mechanism to tune and/or adjust the frequencies of the laser light emitted therefrom, as is commonly understood.

The recirculator 22 is positioned near the corner of the substrate 16 at which the light sources 18 and 20 are aimed. In one embodiment, the recirculator 22 is a mirror with a very high reflectivity (e.g., above 95%) and a non-zero transmittance. As is commonly understood, the recirculator 22 may have a reflectivity for a desired state of polarization of light that is significantly higher than the reflectivity for the state of polarization of light that is orthogonal to the desired state of polarization of light. As will be described in greater detail below, the recirculator 22 is shaped to focus light propagating from the light sources 18 and 20 to the optical fiber 14 and to reflect and focus light propagating from each end of the optical fiber 14 towards and into the opposite end of the optical fiber 14. The partial transmittance of the recirculator 22 allows a portion of the light from each of the light sources 18 and 20 into the optical fiber 14 and a portion of the light circulating in the optical fiber 14 to be transmitted to the beam splitters 24 and 26.

The first beam splitter 24 is positioned between the first light source 18 and the recirculator 22, and the second beam splitter 26 is positioned between the second light source 20 and the recirculator 22. Although not illustrated in detail, the first and second beam splitters 24 and 26 are preferably oriented at an angle (e.g., 45 degrees) relative to a line interconnecting the respective first and second light sources 18 and 20 and the recirculator 22.

The first and second photo-detectors 28 and 30 are positioned on the substrate 16 on sides of the first and second beam splitters 24 and 26, respectively, near a central portion of the substrate 16. Additionally, although not specifically illustrated, the first and second photo-detectors 28 and 30 are directed at central portions of the first and second beam splitters 24 and 26, respectively. In one embodiment, the first and second photo-detectors 28 and 30 each include a photodiode having a germanium-doped region formed on the substrate 16. In another embodiment, the photo-detectors 28 and 30 include discrete photo-detector chips made of, for example, germanium or indium gallium arsenide phosphide (InGaAsP).

The controller 32 (or processing subsystem), in one embodiment, is formed on or within the substrate 16, and may include electronic components, including various circuitry and/or integrated circuits (e.g., a microprocessor and a power supply), such as an Application Specific Integrated Circuit (ASIC) and/or instructions stored on a computer readable medium to be carried out by the microprocessor to perform the methods and processes described below. As shown, the controller 32 is in operable communication with and/or electrically connected to the first and second light sources 18 and 20, the first and second photo-detectors 28 and 30, and the transmitter 34. The transmitter 34 is formed on the substrate 16 and includes, for example, a radio frequency (RF) transmitter, as is commonly understood.

In one embodiment, the IOC 12 and/or the substrate 16 is a "silicon optical bench," as is commonly understood, and includes a series of trenches (or waveguides) 38 formed within the substrate 16. The trenches 38 interconnect the first and second light sources 18 and 20, the first and second beam splitters 24 and 26, the first and second photo-detectors 28 and 30, and the recirculator 22. The substrate 16 also includes two grooves 42 formed in an outer wall near the respective corner of the substrate 16. Optical components are created from the substrate 16 or are embedded into the substrate 16.

The optical fiber 14 has a first end 44, a second end 46, and in one embodiment, is wound in a coil of a diameter of, for example, between 15 and 150 mm. The optical fiber 14 is, in one embodiment, a glass-based, solid core, optical fiber with an extremely low bend loss and a Verdet constant typically above 10⁻⁶ rad/G/cm. Alternatively the optical fiber 14 may be a hollow core fiber filled with a material of high Verdet constant. As shown, the first end 44 of the optical fiber 14 is inserted into the groove 42 opposite the first light source 18 and is physically attached to the recirculator 22. The second end 46 of the optical fiber is inserted into the groove 42 opposite the second light source 20 and is physically attached to the substrate 12. The ends of the fiber are anti-reflection coated and angle polished to mimimize losses and back-reflections for the light transition between the fiber and free space. A central portion of the optical fiber 14 may bend around the respective corner of the substrate 16 in a substantially circular manner.

As is discussed in greater detail below, the recirculator 22 and the first and second ends 44 and 46 of the optical fiber 14 are positioned such that the recirculator 22 receives, and reflects, a large majority of the light from second end 46 into the first end 44, thus forming a resonator for light traveling in a first (i.e., clockwise (CW)) direction. Likewise, the recirculator 22 is positioned to reflect a large majority of the light exiting the first end 44 into the second end 46 of the optical fiber 14, thus forming a resonator in a second (i.e., counterclockwise (CCW)) direction. The recirculator 22 focuses, or spatially conditions, the light to minimize fiber-end to fiber-end optical losses.

As such, the optical fiber 14 and the recirculator 22 jointly form an optical ring resonator, or a resonant optical path loop, with an opening 62 there through. The optical ring resonator has resonant frequencies in the CW and CCW directions determined by the roundtrip optical path length inside the resonator path (i.e., optical path loop) in each direction, respectively.

An electrical conductor (e.g., a wire) 64 is inserted through the area 62 enclosed by the resonator. The conductor 64 is disconnected prior to insertion through the resonator. Although not shown, the conductor 64 may be a component of a larger electrical system, such as an electrical system within an aerospace vehicle or an electric power utility for, for example, a fuel cell in an automobile, a generator or motor, or a welding system.

During operation, the controller 32 activates the first and second light sources 18 and 20 such that the first and second light sources 18 and 20 emit light, such as laser light (e.g., with a wavelength of approximately 830, 1310, and/or 1550 nm), towards the respective first and second beam splitters 24 and 26. More specifically, the first light source 18 emits a first beam, or portion, of laser light towards the first beam splitter 24, and the second light source 20 emits a second beam, or portion, of laser light towards the second beam splitter 26. The beam splitters 24 and 26 are arranged such that a significant fraction of the light from the light sources 18 and 20 passes there through. The first and second beams of light propagate through the free space inside the trenches 38 towards the recirculator 22. Although not specifically illustrated, the sensor 10 may also include one or more waveplates through which the light passes before reaching the recirculator 22 to ensure that the laser light is circularly polarized.

Assuming that the resonator is at or near resonance, at least a portion of the first beam passes through, or is transmitted by, the recirculator 22 and to the first end 44 of the optical fiber 14. Likewise, at least a portion of the second beam passes through the recirculator 22 and to the second end 46 of the optical fiber 14. The first beam thus propagates through the optical fiber 14, or around the resonator, in a first, or clockwise, direction (CW), while the second beam propagates around the resonator in a second, or counterclockwise, direction (CCW).

Assuming the resonator is at or near resonance, the first and second beams continue through the optical fiber 14 in their respective opposing directions. The first beam then propagates from the second end 46 of the optical fiber 14, and the second beam propagates from the first end 44 of the optical fiber. As the first beam exits the second end 46 of the optical fiber 14, the light wave spatially diverges, and thus "fans out". However, as the light strikes the recirculator 22, a majority of the first beam is reflected and may be recollimated towards the first end 44 of the optical fiber 14. Likewise, the second beam exits the first end 44 of the optical fiber 14 and a majority of the second beam is reflected and may be recollimated by the recirculator 22 towards the second end 46 of the optical fiber 14. This process is continually repeated as the light circulating through the optical fiber 14 resonates within the resonator path.

As previously suggested, not all of the first and second beams are reflected by the recirculator 22. A relatively small portion of each passes through (i.e., is transmitted) the recirculator 22 when the resonator is at or near resonance. More specifically, at least some of the first beam is transmitted by the recirculator 22 and propagates towards the second beam splitter 26, and at least some of the second beam is transmitted by the recirculator 22 and propagates towards the first beam splitter 24. Although not specifically shown, the second beam splitter 26 reflects the portion of the first beam onto the second photo-detector 30, and the first beam splitter 24 reflects the portion of the second beam onto the first photo-detector 28. The photo-detectors 28 and 30 are capable of detecting the light portions returning from the beamsplitters 24 and 26. The detected light portions have resonance line shapes with center frequencies indicative of phase shifts, or resonance frequency differences in the two directions (i.e., CW and CCW), as caused by any changes in the effective optical path experienced by the first and second beams while propagating around the resonator enclosing electric current flow.

As will be appreciated by one skilled in the art, when current is conducted, or flows, through the conductor 64, a magnetic field is generated within the opening 62 of the resonator. The generated magnetic field causes a change in the index of refraction for circularly polarized light passing through the optical fiber 14. More particularly, the current, and the resulting magnetic field, effectively increase the index of refraction for the beam of light propagating around the resonator in one direction (CW or CCW), while effectively decreasing the index of refraction for the beam of light propagating in the opposing direction. Thus, the current conducted through the opening 62 causes the index of refraction for the light propagating in, for example, the CW direction to change from a first value to a second value, while the index of refraction for the light propagating in the CCW direction changes from a third value to a fourth value. By design of a reciprocal device, namely light traveling along a common path in opposite directions except for the Faraday Effect, the first and third values may be substantially equal. The change in the index of refraction alters the effective optical path lengths for the first and second beams, and thus shifts the resonance frequencies thereof in the resonator.

The photo-detectors 28 and 30 detect an intensity of the light beams. As such, the first and second photo-detectors 28 and 30 send electrical signals to the controller 32 which represent the absence or presence of constructive interference (within the resonator) of the individual light waves within the first beam at the second photo-detector 30 and the second beam at the first photo-detector 28. Such interference appears as a resonance dip at each photo-detector 28 and 30, as is commonly understood. The controller 32 utilizes the information provided by the photo-detectors 28 and 30 to tune the first and second light sources 18 and 20 to the respective frequencies at which resonance occurs for the amount of current that is flowing through the conductor 64. The controller 32 then calculates a difference between the resonance frequencies for the first and second beams, and determines the amount of current flowing through the conductor 64 based on the difference in the resonance frequencies. The determination of the amount of current may be based on the known properties of the fiber coil 14 and light sources 18 and 20..

Other embodiments may utilize different configurations of optical components. For example, the focusing and collimation of the light into the resonator may be performed by lenses formed or placed on the substrate 16 between each beam splitter and the recirculator. The trenches may be replaced with waveguides formed within the substrate.

The controller 32 modulates the current in the lasers 18 and 20, and therefore the power in lasers 18 and 20, by an equal percentage of their average power. If the Kerr effect is not compensated, then the current modulation also modulates the optical power on the detectors 28 and 30 and more importantly the resonance frequency difference between the CW and CCW beams. The controller 32 measures this frequency difference modulation and then adjusts the DC current of the two lasers 18 and 20 to null the difference modulation, thereby compensating the Kerr effect.

Alternatively, two optical attenuators (not shown) may be employed, located between the laser 20 and splitter 26, the other between laser 18 and splitter 24. The controller 32 modulates the attenuators to attenuate the power of each light beam by equal percentages and determines the resulting modulation in resonance frequency difference. The controller then servos the DC level of the optical attenuators to null the frequency difference modulation, thereby compensating the Kerr effect. An example RFOG that includes a feedback control circuit for performing Kerr effect compensation is shown and described in U.S. Patent Ser. No. 4,673,293, which is hereby incorporated by reference.

While the preferred embodiment of the invention has been illustrated and described, as noted above, many changes can be made without departing from the spirit and scope of the invention. Accordingly, the scope of the invention is not limited by the disclosure of the preferred embodiment. Instead, the invention should be determined entirely by reference to the claims that follow.

## Claims

1. A resonator apparatus for sensing current comprising:
an optical fiber (14) having first and second opposing ends;
a recirculator (22) configured such that when light propagates from the respective first and second ends of the optical fiber, at least some of the light is directed by the recirculator into the respective opposing ends of the optical fiber to propagate through the optical fiber and form an optical loop having an opening there through; and
a sensing component (10) comprising at least one loop of the optical fiber configured to sense current that passes through the area enclosed by the at least one loop,
wherein the optical fiber has a Verdet constant of at least 10⁻⁶ radian/Gauss-cm.

2. The apparatus of Claim 1, wherein a first portion of the light propagates around the optical loop in a first direction and a second portion of the light propagates around the optical loop in a second direction and wherein when the current flowing through the area enclosed by the loop changes, the index of refraction changes from a first value to a second value in a first direction around the optical fiber and from a third value to a fourth value in a second direction around the optical fiber, wherein the ends of the optical fiber are fixedly positioned in proximity to the recirculator.

3. The apparatus of Claim 2, wherein the ends are fixedly positioned in proximity to the recirculator by a least one of a glass solder or an optical epoxy.

4. The apparatus of Claim 2, wherein at least some of the first and second portions of the light are transmitted by the recirculator, the apparatus further comprising a first photo-detector configured to capture the at least some of the first portion of light transmitted by the recirculator and a second photo-detector configured to capture at least some of the second portion of the light transmitted by the recirculator, further comprising at least one light source and corresponding optical attenuators operable to emit the first and second portions of light toward the recirculator, and wherein the recirculator is further configured such that the first and second portions of light are transmitted by the recirculator and propagate into the respective first and second ends of the optical fiber, wherein the at least one light source comprises first and second tunable light sources to emit the respective first and second portions of the light, the apparatus further comprising a processor in operable communication with the first and second tunable light sources and the first and second photo-detectors and configured to tune the first and second tunable light sources and determine first and second resonance frequencies of the resonator apparatus, wherein the processor is further configured to determine a difference between the first and second resonance frequencies, the difference being proportional to the current flowing through the opening in the optical loop.

5. The apparatus of Claim 4, wherein the processor is configured to provide frequency control signals or power control signals to the at least one light source or optical attenuators to maintain the light source frequencies at said first and second resonance frequencies, a difference in said first and second resonance frequencies being related to current flowing through the opening in the optical loop, or control the optical power in the first and second portions of light to compensate for nonlinear effects, one of the nonlinear effects being the Kerr effect.

6. A current sensing method performed by an optical resonator, the method comprising:
propagating light into first and second ends of an optical fiber;
reflecting at least some of the propagated light by a recirculator into the respective opposing ends of the optical fiber, the optical fiber forming an opening; and
determining the resonance frequencies of the optical resonator;
sensing a shift in resonant frequencies due to current flowing through the area enclosed by the opening and the determined resonance frequencies of the optical resonator,
wherein the optical fiber has a Verdet constant typically greater than 10⁻⁶ radian/Gauss-cm.

7. The method of Claim 6, wherein propagating comprises propagating a first portion of the light around the optical loop in a first direction and a second portion of the light around the optical loop in a second direction and wherein when the current flowing through the opening in the optical loop changes, the index of refraction changes from a first value to a second value in the first direction and from a third value to a fourth value in the second direction, wherein the ends of the optical fiber are fixedly attached in proximity to the recirculator, the ends are attached to a substrate by a least one of a glass solder or an optical epoxy and at least some of the first and second portions of the light are transmitted by the recirculator, wherein sensing comprises capturing at a first photo-detector at least some of the first portion of light transmitted by the recirculator and at a second photo-detector at least some of the second portion of the light transmitted by the recirculator.

8. The method of Claim 7, wherein propagating comprises emitting the first and second portions of light from at least one light source toward the recirculator, wherein the at least one light source comprises first and second tunable light sources, further comprising tuning the first and second tunable light sources and determining first and second resonance frequencies of the optical resonator based the captured first and second portions of light.

9. The method of Claim 8, wherein sensing comprises determining a difference between the first and second resonance frequencies and determining the current flowing through the opening in the optical loop based on the determined difference, the method further comprises providing a frequency control signal to the at least one light source to maintain the light source frequencies at said first and second resonance frequencies, a difference in resonance frequencies being related to current flowing through the opening in the optical loop.

10. The method of Claim 9, further comprising providing power control signals to the at least one light source or included one or more optical attenuators, thereby controlling the optical power in the first and second portions of light to compensate for nonlinear effects.
